# FASCICULE DE BREVET EUROPEEN

(11) **EP 3 180 810 B1**
(45) Date de publication et mention de la délivrance du brevet: **27.06.2018**
(21) Numéro de dépôt: 15757334.6
(22) Date de dépôt: 13.07.2015
(51) Int. Cl.: B01J 37/34, C01G 23/047, C01B 32/05, H01L 51/46, H01L 51/48

(54) **PROCÉDÉ DE SYNTHÈSE DE NANOCOMPOSITES À BASE DE TIO2 ET DE NANOSTRUCTURES CARBONÉES**
VERFAHREN ZUR SYNTHESE VON NANOVERBUNDSTOFFEN AUF BASIS VON TIO2- UND KARBONIERTEN NANOSTRUKTUREN
METHOD FOR THE SYNTHESIS OF NANOCOMPOSITES BASED ON TIO2 AND CARBONATED NANOSTRUCTURES

(30) Priorité: 15.07.2014 FR 1456802
(43) Date de publication de la demande: 21.06.2017
(73) Titulaire: Commissariat à l'Énergie Atomique et aux Énergies Alternatives, 75015 Paris (FR); Centre National de la Recherche Scientifique, 75016 Paris (FR); Universite de Limoges, 87032 Limoges Cedex 01 (FR)
(72) Inventeur: HERLIN, Nathalie, F-91400 Orsay (FR); WANG, Jin, Zhejiang Province (CN); PINAULT, Mathieu, 94260 FRESNES (FR); BOUCLE, Johann, F-16420 Brigueuil (FR)
(74) Mandataire: Gevers & Orès
(86) Numéro de dépôt international: PCT/IB2015/055289
(87) Numéro de publication internationale: WO 2016/009328

(56) Documents cités:
- QIMING CAO ET AL: "Titania/carbon nanotube composite (TiO2/CNT) and its application for removal of organic pollutants", CLEAN TECHNOLOGIES AND ENVIRONMENTAL POLICY, vol. 15, no. 6, 18 janvier 2013 (2013-01-18), pages 871-880, XP055178467, ISSN: 1618-954X, DOI: 10.1007/s10098-013-0581-y
- R S CASTRO1 ET AL: "Structure, wettability and photocatalytic activity of CO2 laser sintered TiO2/multi-walled carbon nanotubes coatings", NANOTECHNOLOGY, vol. 19, 14 février 2008 (2008-02-14), page 105704, XP055178736,
- R Alexandrescu ET AL: "Home Search Collections Journals About Contact us My IOPscience TiO 2 nanosized powders by TiCl 4 laser pyrolysis", NANOTECHNOLOGY Nanotechnology, 17 février 2004 (2004-02-17), pages 537-545, XP055178481, Extrait de l'Internet: URL:http://iopscience.iop.org/0957-4484/15 /5/023/pdf/0957-4484_15_5_023.pdf [extrait le 2015-03-23]
- Elisabetta Borsella ET AL: "Synthesis of nanoparticles by laser pyrolysis: from research to applicatoions", Studi & Richerce, 4 mai 2011 (2011-05-04), pages 54-64, XP055178473, Extrait de l'Internet: URL:http://www.afs.enea.it/project/webenea /EAI/SS-Synthesis.pdf [extrait le 2015-03-23]
- PINGFAN DU ET AL: "Dye-sensitized solar cells based on anatase TiO2/multi-walled carbon nanotubes composite nanofibers photoanode", ELECTROCHIMICA ACTA, vol. 87, 2 octobre 2012 (2012-10-02), pages 651-656, XP055178527, ISSN: 0013-4686, DOI: 10.1016/j.electacta.2012.09.096
- GOLOBOSTANFARD MOHAMMAD REZA ET AL: "Hierarchical porous titania/carbon nanotube nanocomposite photoanode synthesized by controlled phase separation for dye sensitized solar cell", SOLAR ENERGY MATERIALS AND SOLAR CELLS, vol. 120, 9 octobre 2013 (2013-10-09), pages 295-302, XP028775085, ISSN: 0927-0248, DOI: 10.1016/J.SOLMAT.2013.09.021

## Description

L'invention concerne un procédé de synthèse de matériaux nanocomposites, en particulier de composites à base de nanostructures de carbone telles que des nanotubes de carbone ou des feuillets de graphène sur lesquelles sont greffées des nanoparticules de TiO₂ ainsi que l'utilisation de ces matériaux composites. Elle vise tout domaine où le mécanisme de séparation et d'extraction des charges est crucial, tel que la photocatalyse, les systèmes photoélectrochimiques ou encore les systèmes photovoltaïques.

Les cellules à pigment (colorant ou chromophore) photosensible à base de TiO₂ (ou cellules de Graetzel) montrent des rendements de conversion élevés (> 15%) mais voient leur développement à grande échelle limité par la présence d'un électrolyte liquide (problèmes de fuite, de corrosion...). Afin de contourner cette limitation, des cellules sensibilisées tout solide sont actuellement développées en remplaçant l'électrolyte par des molécules organiques conductrices de trous. De telles cellules montrent actuellement des rendements inférieurs à 10% (meilleur rendement « certifié » 6%). Dans ces systèmes, les principaux facteurs limitant l'amélioration des rendements sont la séparation et la collecte des charges après la génération de la paire électron - trou. Plusieurs approches sont utilisées pour améliorer le rendement de ces cellules, par exemple en améliorant l'absorption, ou en travaillant les matériaux pour diminuer les pertes par recombinaison.

Dans la plupart des approches « classiques », un important travail de chimie est réalisé pour optimiser la formulation chimique du colorant. L'objectif est alors d'adapter les niveaux d'énergie du colorant absorbant la lumière à ceux des porteurs de charge, limitant ainsi les pertes. Une stratégie consiste à développer des matériaux hybrides contenant des nanotubes de carbone (NTC). L'idée est ici de tirer parti des propriétés de conduction des NTC, en général fonctionnalisés par des chromophores ou couplés à des nanoparticules ou des polymères, pour améliorer la séparation et le transfert des charges. Plusieurs publications ont exploré les potentialités d'architectures TiO₂/NTC et ont montré une nette amélioration des rendements de photocatalyse ou de photo-électrocatalyse avec ces architectures composites. Les auteurs suggèrent que l'amélioration des rendements est liée à la diminution des taux de recombinaison des paires électron - trou due à la meilleure séparation des charges en présence de NTC. Outre l'intérêt pour la photocatalyse, cette architecture présente donc aussi de fortes potentialités pour l'élaboration de cellules photovoltaïques au rendement amélioré. A ce propos, une approche similaire a démontré une nette amélioration de + 30 % des performances dans la génération de photocourant (Incident Photo Current Efficiency 70 %) en comparant une structure incorporant des nanofeuillets de graphène/colorant/nanoparticules et une structure colorant/nanoparticules. Dans ce contexte, l'association des nanoparticules et des nanostructures carbonées est un point essentiel.

L'invention propose une méthode originale et efficace pour associer des nanoparticules de TiO₂, qui sont un élément de base de la couche poreuse du système photosensible, et des nanotubes de carbone ou toute autre structure carbonée. Les composites produits par ce procédé montrent un avantage certain par rapport à ceux obtenus par une méthode de greffage classique de chimie à la fois dans les domaines du photovoltaïque et de la photocatalyse.

Dans tout le texte, on appellera :
- Nanoparticules, des particules solides de dimensions nanométriques ;
- Nanostructures de carbone, des structures de carbone de dimensions nanométriques, par exemple tout type de nanotubes de carbone (NTC) quel que soit leur procédé d'obtention. Il peut s'agir de nanotubes à une seule couche de graphène (SWNT), des nanotubes à plusieurs couches de graphène (MWNT) ou un mélange de nanotubes SWNT et de nanotubes MWNT, ces nanotubes pouvant être dopés - à l'azote par exemple - ou non dopés ; il peut aussi s'agir de feuillets de graphène oxydé ou non ;
- Nanocomposite, un corps composé d'une nanostructure de carbone sur laquelle sont greffés des nanoparticules ; dans le texte, ne sont envisagés que des nanocomposites comportant des nanoparticules de TiO₂ ;
- Nano-objets : un mélange de nanoparticules et de nanocomposites.

### Etat de l'art

Pour améliorer le transfert des charges entre les NTC et le TiO₂, l'état de l'art propose deux approches : soit on part des deux espèces distinctes que l'on associe, dite approche *ex situ,* soit on fait croître les nanoparticules de TiO₂ directement à la surface des NTC.

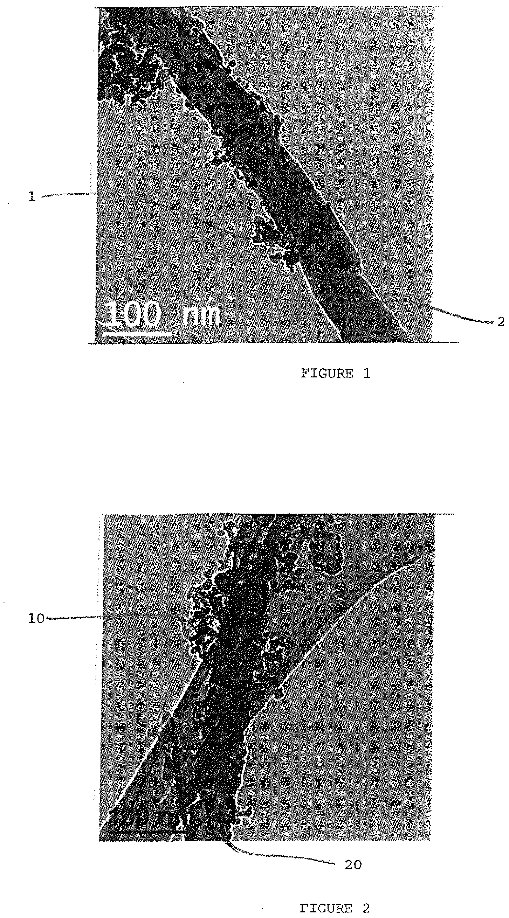

Dans l'approche *ex situ*, on associe les deux espèces préalablement formées. Le procédé le plus développé consiste tout d'abord en une attaque chimique de la surface des NTC afin de créer des défauts et des liaisons de type -COO- en surface. Les nanoparticules sont ensuite mises en contact avec ces NTC au sein d'une suspension et s'accrochent à la surface des nanotubes sur ces sites. La figure 1 est une photo qui illustre le résultat obtenu, appelé plus loin Echantillon ex situ. Comme il est visible sur cette figure, très peu de nanoparticules de TiO₂ 1 sont greffées sur le nanotube 2.

L'état de l'art décrit aussi une méthode comprenant l'association de ces espèces par leur approvisionnement simultané (nanotubes et nanoparticules de TiO₂) dans une zone de réaction, telle que la combustion (US 2012/0107683, Kim et al.). Par cette méthode, l'association semble efficace et une amélioration des propriétés de transfert de charge est atteinte mais cela nécessite d'avoir préalablement synthétisé les deux espèces.

Une autre voie connue est la croissance des nanoparticules directement à la surface des NTC. Une des voies permettant ce type de synthèse est la voie dite « sol gel » (Z. Li et al., Carbon nanotube/titanium dioxide (CNT/ TiO2) core-shell nanocomposites with tailored shell thickness, CNT content and photocatalytic/photoelectrocatalytic properties, Applied Catalysis B: Environmental, Volume 110, 2 November 2011, Pages 50-57). Les nanotubes sont dans ce cas bien couverts et les performances des composites sont intéressantes comparées aux nanoparticules seules. De façon préliminaire à la synthèse des TiO₂, il faut faire une attaque chimique des NTC ; la synthèse réclame alors un temps d'attente et plusieurs étapes. Contrairement aux méthodes de combustion évoquées plus haut, il s'agit d'une méthode de synthèse par lots.

QIMING CAO ET AL: CLEAN TECHNOLOGIES AND ENVIRONMENTAL POLICY, vol. 15, no. 6, 18 janvier 2013, pages 871-880, PINGFAN DU ET AL: ELECTROCHIMICA ACTA, vol. 87, 2 octobre 2012, pages 651-656 et GOLOBOSTANFARD MOHAMMAD REZA ET AL: SOLAR ENERGY MATERIALS AND SOLAR CELLS, vol. 120, 9 octobre 2013, pages 295-302, divulguent des nanocomposites comportant des nanoparticules de TiO2 fixées sur des nanostructures de carbone. R S CASTRO1 ET AL: NANOTECHNOLOGY, vol. 19, 14 février 2008, page 105704 divulgue une pyrolyse laser appliquée à une couche Ti02/ MWCNTs, cette pyrolyse est effectuée après la formation des nanoparticules TiO2 (ex situ). R Alexandrescu ET AL: NANOTECHNOLOGY, 17 février 2004, pages 537-545 et Elisabetta Borsella ET AL: Studi & Richerce, 4 mai 2011, pages 54-64 divulguent des nanoparticules TiO2 synthétisées directement (in situ) par pyrolyse laser, mais ils sont silencieux sur l'application de la pyrolyse laser à une composite TiO2/CNTs.

### Description de l'invention

En vue d'améliorer le transfert de charges à l'aide d'un composite de nanoparticules de TiO₂/nanostructures de carbone, l'invention propose un procédé de synthèse d'un composé nanocomposite comportant des nanoparticules de TiO₂ fixées sur des nanostructures de carbone, comprenant les étapes suivantes :
a) Mélanger dans un premier liquide, pour former une suspension mère, des nanostructures de carbone et au moins un précurseur de TiO₂,
b) Nébuliser ladite suspension mère et la transporter par un flux gazeux dans une chambre de réaction,
c) Réaliser une pyrolyse laser de ladite suspension mère dans ladite chambre de réaction pour simultanément former des nanoparticules de TiO₂ et les greffer aux nanostructures.

L'idée générale de l'invention est de synthétiser directement les nanoparticules de TiO₂ à la surface des nanostructures de carbone, ce qui permet de plus une production continue donc plus facilement transposable pour une application industrielle qu'une technique de type « production par lots ».

La synthèse du nanocomposite repose sur la croissance de TiO₂ sur le produit carboné lors de son passage dans un faisceau laser, cette croissance in-situ assurant une accroche solide des nanoparticules de TiO₂ sur la surface carbonée. La réaction de pyrolyse laser entre les nanostructures carbonées et le précurseur de nanoparticules a lieu dans une enceinte appelée chambre de réaction.

Le procédé comprend une étape consistant à mélanger des nanostructures de carbone et un précurseur de TiO₂ dans un premier liquide de façon à obtenir une suspension homogène de nanostructures dans le précurseur, puis à faire passer ce mélange, de préférence sous forme de gouttelettes, dans le faisceau d'un laser CO₂ permettant la croissance des nanoparticules de TiO₂.

Les liquides utilisables sont ceux dans lesquels les nanostructures de carbone peuvent être dispersées et qui ne réagissent pas spontanément avec le précurseur de TiO₂. Si ce précurseur est le tétraisopropoxyde de titane (TTIP), un liquide convenable sera par exemple le toluène, le xylène, l'alcool, l'acétone.

D'autres précurseurs de TiO₂ tel que le tétrachlorure de titane ou encore les alkoxydes de titane, en particulier l'éthoxyde de titane, l'isopropoxyde de titane, le butoxyde de titane sont couverts par l'invention.

De façon connue dans l'état de l'art, le premier liquide et le précurseur de TiO₂ doivent être compatibles pour éviter toute réaction entre ce liquide et le précurseur.

L'homme du métier connaît différentes techniques permettant de préparer des nanostructures carbonées, en particulier des nanotubes de carbone. A titre d'exemples, on peut citer les procédés physiques basés sur la sublimation du carbone tels que des méthodes d'arc électrique, d'ablation laser ou utilisant un four solaire et les procédés chimiques consistant à pyrolyser des sources carbonées sur des catalyseurs métalliques et s'apparentant au procédé de dépôt chimique en phase vapeur (CVD) tels que notamment le procédé de dépôt chimique en phase vapeur, catalytique, assisté par aérosol (CCVD) décrit par Castro et al. (2013, « The role of hydrogen in the aerosol-assisted chemical vapor deposition process in producing thin and densely packed vertically aligned carbon nanotubes », Carbon, vol. 61, pages 585-594). De même, Hilding et al. (2003, « Dispersion of carbon nanotubes in liquids », Journal of dispersion science and technology, vol. 24, pages 1-41) décrivent différentes techniques utilisables pour préparer des nanotubes de carbone.

Lorsque le premier liquide est le toluène et le précurseur de TiO₂ est le TTIP, les proportions utilisées sont les suivantes :
- TTIP : de 90 % à 95 % en masse,
- NTC : de 0,01 % à 0,10 % en masse,
- Toluène : de 4 % à 10 % en masse,
le total faisant 100 % en masse.

On obtient de façon reproductible des nanocomposites carbonés comportant un taux de couverture en TiO₂ élevé, alors que :
- On pouvait craindre que les nanostructures de carbone soient endommagées lors de la pyrolyse laser,
- Du fait de son hétérogénéité, la réaction de nucléation du TiO₂ sur des nanostructures de carbone est difficile à contrôler ; on pouvait donc craindre qu'elle ne se développe pas ou très peu lors de la pyrolyse laser et que l'on obtienne quasi exclusivement du TiO₂ non greffé.

Avantageusement, l'étape a) de mélange peut être précédée par les étapes suivantes :
- Ajouter des nanostructures de carbone dans un liquide de dispersion pour former une suspension préparatoire,
- Disperser les nanostructures de carbone dans la suspension préparatoire.

On ajoute les nanostructures à une concentration comprise entre 0,01 % et 5 % en masse, de préférence entre 0,5 % et 1 % en masse.

Il est souhaitable de disperser les nanostructures dans une solution préparatoire afin de les individualiser pour permettre ultérieurement une bonne association avec les particules de TiO₂. Différents traitements bien connus de l'homme du métier pourront être utilisés pour obtenir une solution homogène. On citera par exemple, les traitements mécaniques par broyage manuel ou à billes, les traitements par agitation à grande vitesse, les traitements par ultra-sons ou encore les traitements par cryogénie.

Des tensioactifs, par exemple du sel de bile (mélange de cholâte de sodium et de désoxycholâte de sodium), de la gomme arabique, sont la plupart du temps employés pour favoriser cette dispersion. Ils permettent également de stabiliser les nanostructures de carbone à l'issue du traitement mécanique.

La concentration en tensioactifs et notamment en tensioactifs non ioniques et/ou en tensioactifs anioniques dans la solution aqueuse est avantageusement comprise entre 0,1 % et 10 % en masse et notamment entre 0,2 % et 5 % en masse.

De façon connue dans l'état de l'art, le tensioactif et le liquide de dispersion choisis doivent être compatibles. Préférentiellement on choisira un liquide de dispersion -protique, Par « liquide de dispersion protique », on entend, dans le cadre de la présente invention, un liquide qui comporte au moins un atome d'hydrogène susceptible d'être libéré sous forme de proton. Avantageusement le liquide de dispersion protique sera choisi parmi l'eau, l'acide acétique, les solvants hydroxylés comme, par exemple, le méthanol et l'éthanol, les glycols liquides de faible poids moléculaire tels que l'éthylèneglycol, et leurs mélanges.

Par « tensioactif », on entend une molécule comportant une partie lipophile (apolaire) et une partie hydrophile (polaire). Avantageusement, le tensioactif est choisi parmi les tensioactifs anioniques, les tensioactifs cationiques, les tensioactifs zwittérioniques, les tensioactifs amphotères et les tensioactifs non-ioniques. La solution aqueuse peut comprendre plusieurs tensioactifs appartenant à une même famille de tensioactifs précédemment listée (i.e. anionique, cationique, zwittérionique, amphotère ou non ionique) ou plusieurs tensioactifs appartenant à au moins deux de ces familles de tensioactifs distinctes.

Les tensio-actifs anioniques sont les plus utilisés pour la dispersion. Ils possèdent une partie hydrophile chargée négativement, qui peut être un groupement sulfate comme le dodécylsulfate de sodium (SDS) et le dodécyl sulfate benzénique de sodium (SDBS), ou un groupement carboxylate comme le cholâte de sodium et le désoxycholâte de sodium.

Le tensio-actif non ionique ne présente pas de charge. Il en existe un grand nombre comme le triton X-100, le Pluronic F127 et F68, les Tween 20 et 80 ou encore le BrijS20. Ce dernier, dans le cadre de l'invention, est préféré pour cette catégorie de tensio-actif.

Avantageusement l'étape de dispersion peut comporter ou être suivie d'une étape d'attaque acide des nanostructures dans la suspension préparatoire de façon à modifier leur état de surface.

Cette attaque acide permet de modifier l'état de surface des nanostructures en créant des liaisons oxygénées -CO et -COO-.

Avantageusement l'étape de dispersion ou d'attaque acide peut être suivie des étapes consistant à :
- Filtrer les nanostructures de façon à les extraire de la suspension préparatoire,
- Les ajouter dans le premier liquide.

Avantageusement, dans l'étape b) d'injection, la suspension mère peut être entraînée par un flux de gaz d'entraînement pouvant comporter ou consister en un gaz sensibilisateur.

La suspension mère de nanostructures et de précurseur de TiO₂ est envoyée dans un générateur de gouttelettes. Les gouttelettes sont entrainées vers la chambre de réaction par un flux de gaz d'entraînement pouvant comprendre un mélange de gaz neutre (par exemple Ar) et de gaz dit sensibilisateur, ou uniquement du gaz sensibilisateur. La fonction de ce gaz sensibilisateur est alors de compenser la faible absorption infra-rouge du précurseur de TiO₂. Cependant on peut aussi envisager de travailler à forte puissance laser sans gaz sensibilisateur.

Le gaz sensibilisateur est avantageusement choisi dans le groupe constitué par l'éthylène, le propadiène, le butadiène, l'acétylène, l'hexafluorure de soufre (SF6), seuls ou en combinaison.

Les gouttelettes sont conduites par le flux gazeux dans le faisceau d'un laser CO₂, permettant d'induire la croissance des nanoparticules de TiO₂ en particulier à la surface des nanostructures avec l'apparition d'une flamme de pyrolyse.

Avantageusement l'étape c) de pyrolyse peut être suivie des étapes suivantes :
- Collecter en voie sèche les nanocomposites produits dans la chambre de réaction,
- Appliquer un traitement thermique auxdits nanocomposites de façon à les débarrasser d'un excès de carbone.

Le composite subit ensuite un traitement thermique sous air afin de le débarrasser du carbone en excès, dû au précurseur et/ou à la décomposition du gaz sensibilisateur.

La figure 2 est une photo qui illustre le résultat obtenu, appelé Echantillon 1. Un grand nombre de nanoparticules de TiO₂ 10 sont greffées sur le nanotube 20.

L'invention porte également sur une utilisation des nanocomposites fabriqués selon le procédé selon l'invention dans la photocatalyse de polluants.

L'invention porte également sur une utilisation des nanocomposites fabriqués selon le procédé selon l'invention dans une couche poreuse d'une cellule photovoltaïque.

### Exemple 1 : Préparation d'un nanocomposite comportant des nanoparticules de TiO₂ fixées sur des nanostructures de carbone.

### Suspension préparatoire :

### On utilise de l'eau comme liquide de disersion.

La suspension préparatoire comporte :
Des nanotubes de carbone en fonction du besoin, leur concentration devant toutefois rester inférieure ou égale à 5 % en masse,
1 % en masse de « sel de bile » (cholâte de sodium et désoxycholâte de sodium).

### Dispersion :

Le traitement aux ultra-sons est appliqué pendant 50 minutes à la suspension préparatoire grâce à une sonde ultrason de 750 W à 50 % de la puissance maximale.

Les propriétés morphologiques, principalement les longueurs et les diamètres des nanotubes de carbone à l'issue de l'étape de dispersion aux ultra-sons, sont vérifiées par les analyses en microscopie optique et la microscopie électronique en transmission. Les mesures permettent également d'observer l'homogénéité de la dispersion des nanotubes. On obtient ainsi des nanotubes d'une longueur moyenne autour de 3 µm, le diamètre étant imposé dès la synthèse des NTC mais n'étant pas modifié par le traitement aux ultra-sons ni l'attaque acide.

### Attaque acide :

Les nanotubes précédemment dispersés sont traités dans la suspension préparatoire à l'aide d'un mélange d'acide sulfurique (75 % en volume) et d'acide nitrique (25 % en volume) concentrés (pH < 3) dans le bac à ultrasons à 50°C pendant 2 heures. Ils sont ensuite filtrés et ré-dispersés pendant quelques minutes aux ultra-sons dans du toluène. Bien entendu, le traitement aux ultra-sons et l'attaque chimique pourraient avantageusement être simultanés.

Après cette étape, des mesures ont été réalisées par prélèvement pour vérifier la formation de liaisons oxygénées et mesurer la quantité de fonctions chimiques ajoutées. L'analyse en spectroscopie infrarouge (IR) valide la présence des groupements -CO (1375 cm⁻¹) et -COO- (1720 cm⁻¹) sur les nanotubes traités, qui proviennent du traitement acide.

### Suspension mère :

Après filtration, les nanotubes sont mis en suspension dans du toluène puis cette suspension est mélangée à un précurseur de TiO₂, le TTIP, avec les quantités suivantes :
- 216,1 mg de nanotubes de carbone,
- 385 g de TTIP,
- 26,1 g de toluène.

### Pyrolyse laser :

Les conditions expérimentales sont données au Tableau 1 ci-dessous.

**Tableau 1 : principales caractéristiques expérimentales ; ρ représente le rapport entre la masse de nanotubes sur la masse de TiO₂ prévisible en supposant un rendement de 100 % pour la conversion de TTIP en TiO₂.**

| | Réactif | | Entraînement | | Laser CO₂ | ρ |
|---|---|---|---|---|---|---|
| | Gaz | Débit (cm³/min) | Gaz | Débit (cm³/min) | Puissance (W) | |
| TiO₂ seul | C₂H₄ | 355 | Ar | 2000 | 640 | 0% |
| Echantillon 1 | C₂H₄ | 355 | Ar | 2000 | 640 | 0,2% |
| Echantillon 2 | C₂H₄ | 355 | Ar | 2000 | 640 | 1 % |

Les débits de gaz sont choisis pour assurer la formation d'une phase majoritaire de structure cristallographique anatase dans le TiO₂ (de l'ordre de 90 %).

Le gaz sensibilisateur choisi est l'éthylène (C₂H₄) car il absorbe efficacement la radiation laser et favorise le transfert collisionnel de l'énergie à la réaction de croissance de TiO₂ à partir de TTIP. De plus, en se décomposant, il n'apporte pas d'hétéroatome supplémentaire au système (C et H sont présents dans le TTIP). D'autres gaz sensibilisateurs pourraient consister, seuls ou en combinaison, en du propadiène, du butadiène, de l'acétylène, du SF₆ ...

Le flux débouche dans la chambre de réaction par une buse qui s'ouvre sous le faisceau laser. La buse se trouve elle-même dans une cheminée concentrique dans laquelle passe un flux d'Argon qui confine la réaction et l'isole des parois de la chambre de réaction. Le faisceau laser pénètre par une fenêtre en KCl (transparente à la longueur d'onde du laser), La fenêtre est refroidie par un ventilateur et protégée d'éventuels dépôts sur sa face intérieure par un balayage d'argon. Il croise le flux de réactifs de manière orthogonale dans la chambre de réaction. Le faisceau laser peut être focalisé par une lentille cylindrique ou sphérique placée sur son chemin optique. La distance entre le faisceau laser et la sortie de la buse d'injection des précurseurs peut être ajustée. La pression à l'intérieur de la chambre de réaction est régulée à une valeur de l'ordre de la pression atmosphérique. Les nano-objets produits dans la chambre de réaction sont entrainés par un pompage vers des barrières filtrantes, où ils sont collectés en voie sèche.

Le faisceau laser ressort de la chambre de réaction par une fenêtre, identique à celle d'entrée et située à son opposé. Il est finalement stoppé par un mesureur de puissance de type calorimètre, refroidi par un circuit d'eau. Le mesureur de puissance permet d'obtenir la puissance du faisceau laser dans le milieu réactionnel, avant et au cours de la réaction et d'en déduire la puissance absorbée pendant la réaction.

Les nanoparticules de TiO₂ germent et croissent lors du passage dans le faisceau laser ; on peut penser en fait qu'elles germent directement sur la surface des nanostructures de carbone en nucléation hétérogène (bien sûr la nucléation homogène du TiO₂ est toujours présente et on obtient pour l'essentiel des nanoparticules de TiO₂).

Ce procédé permet d'obtenir des nanocomposites de morphologie contrôlée de petite taille, entre 3 et 35 nm, avec une distribution en taille généralement étroite (10 à 15% autour de la moyenne) et une cristallographie contrôlée. La poudre obtenue est de couleur noire.

### Traitement thermique :

Un traitement thermique est effectué sous air pour débarrasser les nanocomposites de l'excès de carbone dû à la décomposition du précurseur de TiO₂ et/ou du gaz sensibilisateur (C₂H₄).

La photo de la figure 2 montre un exemple de NTC couvert de TiO₂ issu de l'échantillon 1 : les nanoparticules de TiO₂ sont solidement fixées sur un NTC individuel : après plusieurs cycles de rinçage et centrifugation, on n'observe pas de changement de morphologie de ces objets qui sont donc très stables.

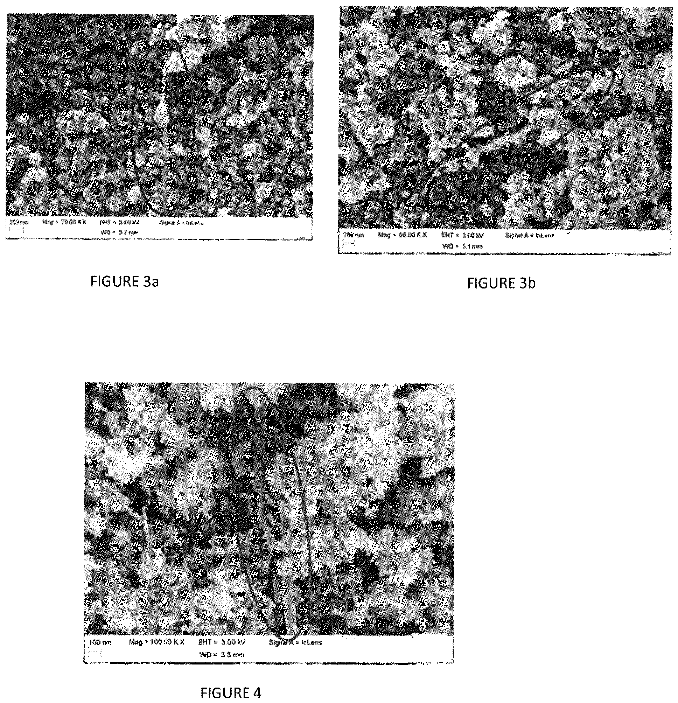

Des nanocomposites « in-situ » NTCs/TiO2 sans traitement acide préalable de la suspension de nanotubes de carbone ont également été synthétisés selon le procédé décrit ci-dessus et comparés à ceux obtenus avec traitement acide préalable. La figure 3 compare la morphologie des poudres NTCs/TiO₂ : la figure 3a correspondant à des nanocomposites obtenus sans traitement préalable de la suspension de NTCs par attaque acide, et la figure 3b correspondant à des nanocomposites obtenus avec un traitement acide préalable. Les figures 3a et 3b montrent un meilleur recouvrement en TiO₂ des nanotubes ayant été préalablement traités en milieu acide.

Des nanocomposites « in-situ » nanotubes de carbone dopés à l'azote/TiO₂ sans traitement acide préalable de la suspension de nanotubes de carbone ont également été synthétisés par ce procédé. Le cliché de microscopie électronique montre clairement la structure en « bambou » typique des NTCs dopés à l'azote et le recouvrement de ceux-ci par les particules de TiO₂ (figure 4).

### Exemple 2 : Préparation d'un nanocomposite comportant des nanoparticules de TiO₂ fixées sur des feuillets d'oxyde de graphène.

Les feuillets d'oxyde de graphène sont mis en suspension dans du toluène ou de l'éthanol puis cette suspension est mélangée à un précurseur de TiO₂, le TTIP. Typiquement 560 mg d'oxyde de graphène sont dispersés dans 30 ml de toluène ou d'éthanol puis ajoutés à 250 ml de la solution de TTIP (échantillons G2, G3 tableau 2). Les feuillets d'oxyde de graphène peuvent également être directement par ultrasons, dispersés dans la solution contenant le précurseur de TiO₂ (échantillons G4, G5 tableau 2).

**Tableau 2**

| **Echantillons** | **Solution de TTIP** | **Solvent de dispersion (30ml)** | **Masse en oxyde de graphène** |
|---|---|---|---|
| **TiO₂:G2** | 250 ml | Ethanol | 560mg |
| **TiO₂:G3** | 250 ml | Toluene | 560mg |
| **TiO₂:G4** | 250 ml | - | 190mg |
| **TiO₂:G5** | 250 ml | - | 56mg |

Les conditions de pyrolyse laser sont identiques à celles de l'exemple 1. Le rapport entre la masse d'oxyde de graphène sur la masse de TiO₂ prévisible en supposant un rendement de 100 % pour la conversion de TTIP en TiO₂ est de 0.9 % en poids pour les échantillons G2 et G3, 0.3% en poids pour l'échantillon G4 et 0.1% en poids pour l'échantillon G5.

Ce procédé permet d'obtenir des nanocomposites de morphologie contrôlée avec une cristallographie contrôlée. La poudre obtenue est de couleur grise.

### Traitement thermique :

Un traitement thermique est effectué sous air pour débarrasser les nanocomposites de l'excès de carbone dû à la décomposition du précurseur de TiO₂ et/ou du gaz sensibilisateur (C₂H₄).

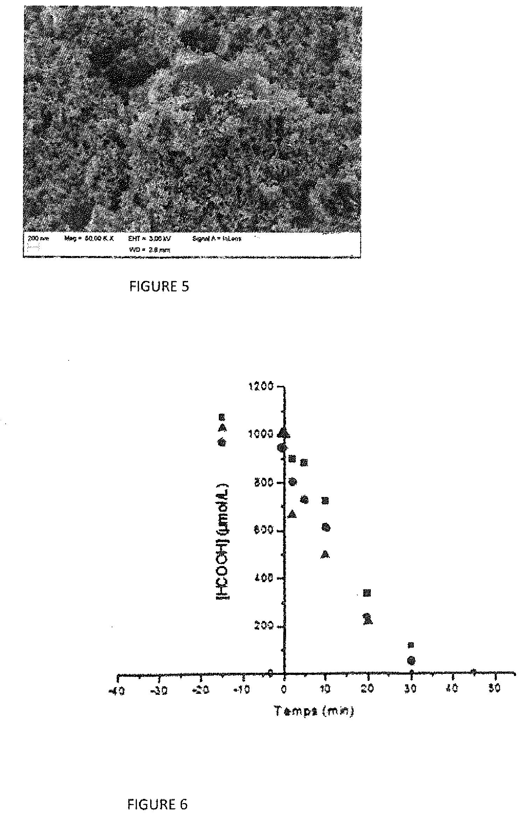

La photo de la figure 5 montre un exemple de feuillet d'oxyde de graphène couvert de TiO₂ obtenu selon le procédé de l'invention.

Pour tous les échantillons (G2 à G5), on observe une décroissance de l'intensité de photoluminescence (« quenching » en langue anglaise) ce qui traduit l'efficacité du transfert électronique du TiO₂ vers le graphène.

### Exemple 3 : préparation de couches poreuses de cellules photovoltaïques.

### Cellule à pigment photosensible :

Les particules obtenues (TiO₂ et nanocomposites de nanoparticules de TiO₂ fixés sur des nanostructures de carbone) ont été utilisées pour l'élaboration de couches poreuses de cellules solaires ou photovoltaïques.

Ces couches poreuses ont été intégrées dans une configuration de cellule solaire sensibilisée à colorant suivant la procédure décrite par Melhem en utilisant les colorants commerciaux D102, D149 (H. Melhem, "Nouvelles électrodes poreuses de TiO2 à base de nanocristaux synthétisés par pyrolyse laser pour cellules solaires sensibilisées à colorants à l'état solide", Thèse (Novembre 2011) et Direct photocurrent generation from nitrogen doped TiO₂ electrodes in solid-state dye-sensitized solar cells: towards optically-active metal oxides for photovoltaic applications. Solar Energy Materials and solar cells, 2013, 117, 624-631).

Le Tableau 3 ci-dessous montre une augmentation très significative du rendement d'une cellule photovoltaïque à colorant D102 faisant usage de nanocomposites correspondant à la figure 2 (Echantillon 1). A titre comparatif, les résultats obtenus pour une couche poreuse à base de TiO₂ sont également reportés dans ce tableau 3.

**Tableau 3 : performances de deux cellules élaborées dans les mêmes conditions (avec colorant D102) mais faisant usage de composites CNT/TiO₂ différents.**

| Composite | Tension en circuit ouvert (V) | Courant de court circuit (mA/cm⁻²) | Facteur de remplissage (FF) | Rendement η |
|---|---|---|---|---|
| Couche poreuse à base de TiO₂ | 0,78 | 5,86 | 0,71 | 3,2 |
| Echantillon ex situ | 0,77 | 6,52 | 0,68 | 3,41 |
| Echantillon 1 | 0,76 | 7,78 | 0,70 | 4,13 |

Le tableau 4 ci-dessous synthétise les performances obtenues en fonction de la nature de la couche poreuse pour des cellules élaborées avec le colorant D149. Les cellules sont élaborées dans les mêmes conditions.

**Tableau 4**

| **Nature de la couche poreuse de la cellule photovoltaïque à colorant D149** | **Tension en circuit ouvert (V)** | **Courant de court-circuit (mA/cm⁻²)** | **Facteur de remplissage (FF)** | **Rendement η** |
|---|---|---|---|---|
| Couche poreuse à base de TiO₂ | 0,78 | 2,20 | 0,53 | 0,9 |
| Composite « in situ » NTCs non traités acide/TiO2 | 0,71 | 4,65 | 0,52 | 1,69 |
| Composite « in situ » NTCs dopés à l'azote et non traités acide/Ti02 | 0,79 | 4,04 | 0,58 | 1,84 |
| Composite « in situ » NTCs traités acide/TiO2 | 0,79 | 4,65 | 0,57 | 2,08 |
| Composite « in situ » graphène/TiO2 | 0,81 | 3,21 | 0,62 | 1,61 |

On remarque dans ce tableau que i) toutes les cellules à base de nanocomposites NTCs/TiO₂ issus du procédé de l'invention ont un rendement supérieur à celui obtenu avec une couche poreuse à base de TiO₂; ii) le rendement d'une cellule photovoltaïque est amélioré lorsque les nanotubes de carbone ont été préalablement traités par attaque acide.

### Exemple 4 : Utilisation des nanocomposites fabriqués selon l'exemple 1 dans la photocatalyse des polluants.

### Dissociation photocatalytique d'un modèle de polluant

50 mg d'échantillon d'un nanocomposite produit par le procédé selon l'invention sont mis sous agitation dans 50 ml d'acide formique. La suspension est laissée dans le noir sous agitation pour atteindre l'équilibre chimique, puis elle est soumise à une irradiation lumineuse et des aliquots sont prélevés régulièrement pour mesurer par chromatographie liquide à haute performance (HPLC) la quantité d'acide formique restant dans la suspension en fonction du temps d'irradiation.

La figure 6 illustre les résultats obtenus avec trois types d'échantillons :
- des nanoparticules de TiO₂ seules (ronds),
- produit de référence (poudre Evonik P25)(carrés),
- et l'échantillon 1 (triangles).

Dans la figure 6, l'axe des abscisses représente le temps en minutes, et l'axe des ordonnées la concentration en acide formique en µmoles/l. Les temps négatifs correspondant à la phase de stabilisation dans le noir.

La vitesse de dissociation de l'acide formique mesurée lorsque l'échantillon consiste en des nanoparticules de TiO₂ seules (ronds) est de 34 micromoles par litre et par minute. La vitesse de dissociation mesurée avec l'échantillon 1 est de 46 micromoles par litre et par minute. Le composite produit par le procédé selon l'invention (triangles) est donc plus efficace que les nanoparticules de TiO₂ seules ou que le produit de référence qui montre une vitesse de dissociation de 29 micromoles par litre et par minute (carrés). On voit donc aussi une amélioration possible dans les procédés de traitement par photocatalyse des polluants.

## Revendications

1. Procédé de synthèse d'un composé nanocomposite comportant des nanoparticules de TiO₂ fixées sur des nanostructures de carbone, qui comprend l'étape suivante:
a) Mélanger dans un premier liquide, pour former une suspension mère, des nanostructures de carbone et au moins un précurseur de TiO₂, **caractérisé en ce qu'**il comprend aussi les étapes suivantes:
b) Nébuliser ladite suspension mère et la transporter par un flux gazeux dans une chambre de réaction,
c) Réaliser une pyrolyse laser de ladite suspension mère dans ladite chambre de réaction pour simultanément former des nanoparticules de TiO₂ et les greffer aux nanostructures.

2. Procédé selon la revendication 1, **caractérisé en ce que** l'étape a) de mélange est précédée par les étapes suivantes :
- Ajouter des nanostructures de carbone dans un liquide de dispersion pour former une suspension préparatoire,
- Disperser les nanostructures de carbone dans ladite suspension préparatoire.

3. Procédé selon la revendication 2, **caractérisé en ce que** l'étape de dispersion est réalisée par application d'ultra-sons à la suspension préparatoire.

4. Procédé selon l'une des revendications 2 ou 3, **caractérisé en ce qu'**en outre, l'étape de dispersion comprend ou est suivie d'une étape d'attaque acide des nanostructures dans la suspension préparatoire de façon à modifier leur état de surface.

5. Procédé selon l'une des revendications 2 à 4, **caractérisé en ce que** l'étape de dispersion ou d'attaque acide est suivie des étapes consistant à :
- Filtrer les nanostructures de façon à les extraire de la suspension préparatoire,
- Les ajouter dans le premier liquide.

6. Procédé selon l'une des revendications précédentes, **caractérisé en ce que** dans l'étape b) d'injection, la suspension mère est entraînée par un flux de gaz d'entraînement pouvant comporter ou consister en un gaz sensibilisateur.

7. Procédé selon l'une des revendications précédentes, **caractérisé en ce que** l'étape c) de pyrolyse est suivie des étapes suivantes :
- Collecter en voie sèche les nanocomposites produits dans la chambre de réaction,
- Appliquer un traitement thermique auxdits nanocomposites de façon à les débarrasser d'un excès de carbone.

8. Utilisation des nanocomposites fabriqués selon le procédé de l'une des revendications 1 à 7 dans la photocatalyse de polluants.

9. Utilisation des nanocomposites fabriqués selon le procédé de l'une des revendications 1 à 7 dans une couche poreuse d'une cellule photovoltaïque.

## Patentansprüche

1. Verfahren zur Synthese einer Nanokomposit-Verbindung, welche TiO₂-Nanopartikel umfasst, die an Kohlenstoff-Nanostrukturen gebunden sind, welches den folgenden Schritt umfasst:
a) Mischen von Kohlenstoff-Nanostrukturen und mindestens einem TiO₂-Vorläufer in eine erste Flüssigkeit, um eine Ausgangssuspension zu bilden,
**dadurch gekennzeichnet, dass** es ebenfalls die folgenden Schritte umfasst:
b) Vernebeln der Ausgangssuspension und Transportieren derselben über einen Gasstrom in eine Reaktionskammer,
c) Ausführen einer Laserpyrolyse der Ausgangssuspension in der Reaktionskammer, um gleichzeitig TiO₂-Nanopartikel zu bilden und dieselben an die Nanostrukturen zu pfropfen.

2. Verfahren nach Anspruch 1, **dadurch gekennzeichnet, dass** dem Schritt a) des Mischens die folgenden Schritte vorangehen:
- Zugeben der Kohlenstoff-Nanostrukturen in eine Dispersionsflüssigkeit, um eine vorbereitende Suspension zu bilden,
- Dispergieren der Kohlenstoff-Nanostrukturen in der vorbereitenden Suspension.

3. Verfahren nach Anspruch 2, **dadurch gekennzeichnet, dass** der Schritt des Dispergierens durch Anwenden von Ultraschall auf die vorbereitende Suspension ausgeführt wird.

4. Verfahren nach einem der Ansprüche 2 oder 3, **dadurch gekennzeichnet, dass** der Schritt des Dispergierens weiter umfasst oder gefolgt wird von einem Schritt des Säureangriffs der Nanostrukturen in der vorbereitenden Suspension, um ihren Oberflächenzustand zu modifizieren.

5. Verfahren nach einem der Ansprüche 2 bis 4, **dadurch gekennzeichnet, dass** dem Schritt des Dispergierens oder des Säureangriffs die Schritte folgen, welch bestehen im:
- Filtern der Nanostrukturen, um sie aus der vorbereitenden Suspension zu extrahieren,
- Zugeben derselben in die erste Flüssigkeit.

6. Verfahren nach einem der vorstehenden Ansprüche, **dadurch gekennzeichnet, dass** im Schritt b) des Einspritzens die Ausgangssuspension durch einen Mitnahme-Gasstrom mitgerissen wird, der ein Sensibilisatorgas umfassen oder aus demselben bestehen kann.

7. Verfahren nach einem der vorstehenden Ansprüche, **dadurch gekennzeichnet, dass** dem Schritt c) der Pyrolyse die folgenden Schritte folgen:
- trockenes Sammeln der in der Reaktionskammer erzeugten Nanokomposite,
- Anwenden einer thermischen Behandlung auf die Nanokomposite, um dieselben von einem Überschuss an Kohlenstoff zu befreien.

8. Verwendung der nach dem Verfahren nach einem der Ansprüche 1 bis 7 hergestellten Nanokomposite in der Photokatalyse von Schadstoffen.

9. Verwendung der nach dem Verfahren nach einem der Ansprüche 1 bis 7 hergestellten Nanokomposite in einer porösen Schicht einer Photovoltaikzelle.

## Claims

1. Method for the synthesis of a nanocomposite compound comprising TiO₂ nanoparticles bound to carbon nanostructures, which comprises the following step:
a) Mixing carbon nanostructures and at least one TiO₂ precursor in a first liquid in order to form a stock suspension,
**characterised in that** it also comprises the following steps:
b) Nebulising said stock suspension and transporting it into a reaction chamber by means of a gaseous flow,
c) Carrying out laser pyrolysis of said stock suspension in said reaction chamber in order to simultaneously form TiO₂ nanoparticles and graft them onto the nanostructures.

2. Method according to claim 1, **characterised in that** the step a) of mixing is preceded by the following steps:
- Adding carbon nanostructures in a dispersion liquid in order to form a preparatory suspension,
- Dispersing the carbon nanostructures in said preparatory suspension.

3. Method according to claim 2, **characterised in that** the step of dispersing is carried out by application of ultrasound to the preparatory suspension.

4. Method according to one of claims 2 or 3, **characterised in that** furthermore, the step of dispersing comprises or is followed by a step of acid etching of the nanostructures in the preparatory suspension in such a way as to modify their surface condition.

5. Method according to one of claims 2 to 4, **characterised in that** the step of dispersing or of acid etching is followed by steps consisting in:
- Filtering the nanostructures in such a way as to extract them from the preparatory suspension,
- Adding them to the first liquid.

6. Method according to one of the preceding claims, **characterised in that** in the step b) of injecting, the stock suspension is driven by a gaseous flow for driving that can comprise or consist of a sensitizer gas.

7. Method according to one of the preceding claims, **characterised in that** the step c) of pyrolysis is followed by the following steps:
- Dry collecting of nanocomposites produced in the reaction chamber,
- Apply a thermal treatment to said nanocomposites in such a way as to free them for an excess of carbon.

8. Use of nanocomposites manufactured according to the method of one of claims 1 to 7 in the photocatalysis of pollutants.

9. Use of nanocomposites manufactured according to the method of one of claims 1 to 7 in a porous layer of a photovoltaic cell.
